# EUROPÄISCHE PATENTSCHRIFT

(11) **EP 3 035 784 B1**
(45) Veröffentlichungstag und Bekanntmachung des Hinweises auf die Patenterteilung: **14.11.2018**
(21) Anmeldenummer: 15196926.8
(22) Anmeldetag: 30.11.2015
(51) Int. Cl.: H05K 13/04

(54) **BAUTEILVERSORGUNGSSTATION FÜR EINEN BESTÜCKUNGSAUTOMATEN**
COMPONENT SUPPLYING STATION FOR AN AUTOMATIC FILLING MACHINE
STATION D'ALIMENTATION DE COMPOSANT POUR UNE MACHINE D'IMPLANTATION DE COMPOSANTS

(30) Priorität: 15.12.2014 DE 102014118610
(43) Veröffentlichungstag der Anmeldung: 22.06.2016
(73) Patentinhaber: Endress+Hauser SE+Co. KG, 79689 Maulburg (DE)
(72) Erfinder: Frey, Volker, 79650 Schopfheim (DE); Schöne, Jenny, 79669 Zell-Gresgen (DE); Senn, Dieter, 79669 Zell (DE); Hippin, Christoph, 79639 Grenzach (DE)
(74) Vertreter: Andres, Angelika Maria

(56) Entgegenhaltungen:
- EP-A1- 0 860 102
- WO-A1-2014/118994
- GB-A- 2 183 820

## Beschreibung

Die Erfindung bezieht sich auf eine Bauteilversorgungsstation, insbesondere ein Feeder für einen Bestückungsautomaten zum Bereitstellen von elektrischen Bauelementen für eine Leiterplatte und ein Verfahren zum Bestücken einer Leiterplatte mit elektrischen Bauelementen.

Die Leiterplattenbestückung umfasst das Setzen und Löten von verschiedenen elektronischen Bauelementen auf eine leere, unbestückte Leiterplatte durch spezifische Setz- und Lötverfahren. Bei der Leiterplattenbestückung können prinzipiell zwei verschiedene Verfahren eingesetzt werden: die SMD-Bestückung (surface mounted device) und die THT-Bestückung (through hole technology).

Die SMD-Bestückung erfolgt dabei meist vollautomatisch und kommt für alle kleinen Bauelemente, wie Widerstände, Kondensatoren und Mikrocontroller zum Einsatz, die meist in großer Anzahl bestückt werden. Die THT-Bestückung muss teilweise von Hand vorgenommen werden. Dies geschieht aus technischen Gründen und um Schäden an den bereits aufgelöteten Bauelementen zu vermeiden. Die THT-Bestückung kommt zumeist bei anzulötenden Leiterplattenverbindern, Steckerleisten und Kabeln zum Einsatz.

Ein Bestückungsautomat ist eine Maschine, die in der Fertigung von Leiterplatten benutzt wird, um Bauelemente auf die Leiterplatte zu platzieren, die anschließend in einem Lötprozess verlötet werden. Die einzelnen Bauteile werden in einer Bauteilversorgungsstation (Feeder) dem Bestückungsautomaten zur Verfügung gestellt. SMD-Bauelemente werden in Form von Blistergurten auf Rollen (Tape & Reel) zur Verfügung gestellt.

Ein Bestückungskopf, der in drei Achsen verfahrbar ist und um die Z-Achse rotieren kann, saugt in der Regel durch Unterdruck ein Bauteil aus dem Blistergurt und platziert das Bauteil auf der Leiterplatte. Sind alle Bauteile bestückt, wird die Leiterplatte über ein Fördersystem weitertransportiert und einem Reflowofen oder Wellenlötanlage zugeführt. Anschließend wird eine weitere leere Leiterplatte oder Leiterplattennutzen in die Bestückungsanlage zugeführt. Meist sind die Bestückungsautomaten modular ausgelegt, so dass man unterschiedliche Bauteilversorgungsstationen, Bestückungsköpfe usw. anbauen kann.

Blistergurte sind Gurte, in denen die zu verarbeitenden Bauelemente verpackt sind. Der Blistergurt ist wie bei einer Filmrolle auf eine Rolle gewickelt.

Ein Beispiel für solche Bauelemente sind Drahtstücke, die zum mechanischen und elektrischen Verbinden an einer Biegestelle einer biegbaren Leiterplatte angebracht werden. Solche Drahtstücke sind einzeln zwischen zwei Plastikstreifen eingepackt. Diese beiden Plastikstreifen mit den einzelnen Drahtstücken dazwischen bilden den Blistergurt.

Die Bauteilversorgungsstation ist relativ zum Bestückungsautomaten dermaßen angeordnet, dass der Blistergurt die einzelnen Bauteile lediglich in einer einzigen vorbestimmten Orientierung relativ zum Bestückungskopf bereitstellt.

Das Dokument EP0860102 offenbart einen Feeder für einen Bestückungsautomaten zum Bereitstellen von elektrischen Bauelementen für eine Leiterplatte, umfassend eine erste Grundplatte, so dass die erste Grundplatte eine vorbestimmte Orientierung relativ zum Bestückungsautomaten einnimmt, eine Fördereinheit zum Fördern eines Blistergurtes, an dem die Bauelemente angeordnet sind, wobei die Fördereinheit relativ zu einer zur ersten Grundplatte senkrechten ersten Achse drehbar gelagert ist, so dass die Bauelemente in der Ebene der ersten Grundplatte in einer vorbestimmten Orientierung relativ zur senkrechten ersten Achse bereitstellbar sind.

Der Erfindung liegt die Aufgabe zugrunde, eine Bauteilversorgungsstation, welche die Bauteile in jeder beliebigen Orientierung relativ zum Bestückungskopf des Bestückungsautomaten bereitstellt, und ein Verfahren zum Bestücken einer Leiterplatte mit elektrischen Bauelementen bereitzustellen.

Die Aufgabe wird erfindungsgemäß durch den Gegenstand der Erfindung gelöst. Der Gegenstand der Erfindung ist eine Bauteilversorgungsstation, gemäß Anspruch 1.

Dadurch, dass die Fördereinheit drehbar gelagert ist, lassen sich die Bauteile auf dem Blistergurt in jeder beliebigen Orientierung zur Grundplatte bereitstellen.

Gemäß einer vorteilhaften Weiterbildung ist ein Bauteilbedruckmodul zum Bedrucken der Bauelemente mit Lot vorgesehen, wobei das Bauteilbedruckmodul relativ zu einer zur zweiten Grundplatte senkrechten zweiten Achse drehbar gelagert ist, und wobei die erste und zweite Achse parallel zueinander angeordnet sind, so dass das Bauteilbedruckmodul an der vorbestimmten Orientierungen der Bauelemente anpassbar ist.

Gemäß einer vorteilhaften Variante weist das Bauteilbedruckmodul eine zweite Grundplatte zum Anstecken an den Bestückungsautomaten auf, so dass die zweite Grundplatte parallel zur ersten Grundplatte angeordnet ist, und wobei das Bauteilbedruckmodul einen Schablonenhalter aufweist, der auf der zweiten Grundplatte angeordnet ist und relativ zur zweiten Achse drehbar gelagert ist, so dass die Bauelemente in der vorbestimmten Orientierung in dem Schablonenhalter platzierbar sind.

Gemäß einer günstigen Weiterbildung sind die erste und zweite Grundplatte als eine einzige Grundplatte ausgebildet, an der sowohl die Fördereinheit als auch das Bauteilbedruckmodul angeordnet ist.

Die Aufgabe der Erfindung wird ebenfalls durch ein Verfahren gemäß Anspruch 5 gelöst.

Gemäß einer vorteilhaften Variante ist ein Bauteilbedruckmodul zum Bedrucken der Bauelemente mit Lot vorgesehen, und wobei das Bauteilbedruckmodul relativ zu einer zu einer zweiten Grundplatte senkrechten zweiten Achse gedreht wird, um das Bauteilbedruckmodul an die vorbestimmte Orientierung der Bauelemente anzupassen, und wobei die Bauelemente nach dem Entnehmen mittels der Vakuumpipette und vor dem Platzieren an der Leiterplatte an dem Bauteilbedruckmodul platziert werden, um mit Lotpaste beaufschlagt zu werden.

Die Erfindung wird anhand der nachfolgenden Zeichnungen näher erläutert.

Es zeigt:
Fig. 1: eine Draufsicht auf eine erste Grundplatte einer Bauteilversorg ungsstation,
Fig. 2: eine Draufsicht einer Bauteilversorgungsstation mit einer Fördereinheit und einer ersten Grundplatte entsprechend Fig. 1,
Fig. 3: eine Draufsicht auf ein Bauteilbedruckmodul, und
Fig. 4: eine perspektivische Ansicht eines Bestückungsautomaten.

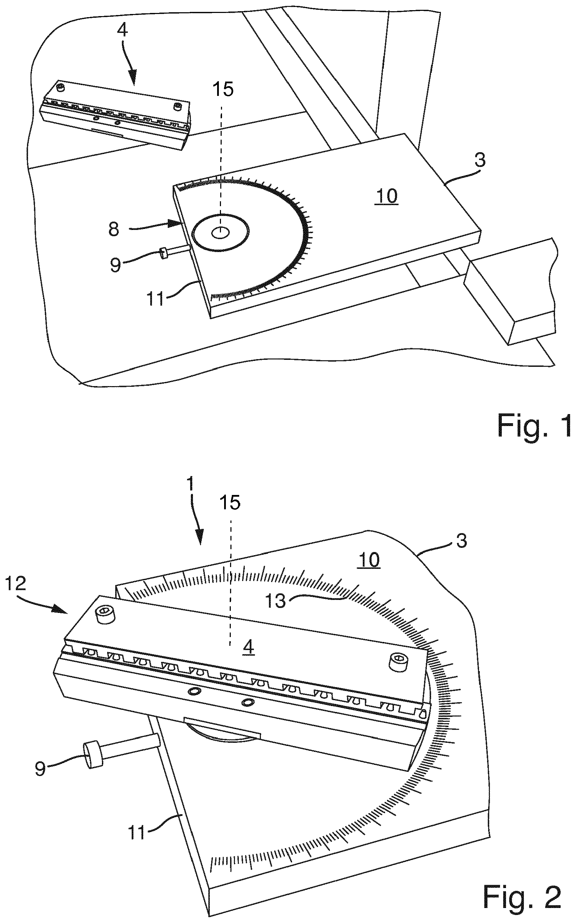

Fig. 1 zeigt eine Draufsicht auf eine erste Grundplatte 3 einer Bauteilversorgungsstation. Die Grundplatte 3 weist auf einer ersten Seitenfläche 10 eine erste Aufnahme 8 für eine Fördereinheit (in Fig. 1 nicht dargestellt) auf. Die erste Aufnahme 8 ist kreisförmig ausgestaltet und in die erste Seitenfläche 10 versenkt. Des Weiteren ist die erste Aufnahme 8 drehbar um eine (gedachte) erste Achse 15 gelagert, die senkrecht auf die erste Seitenfläche 10 steht. Die erste Grundplatte 3 weist eine zweite Seitenfläche 11 auf, die senkrecht zur ersten Seitenfläche 10 angeordnet ist. In die zweite Seitenfläche ist ein Stift 9 versenkt, welcher die erste Aufnahme 8 in einer bestimmten Orientierung relativ zu der ersten Grundplatte 3 festsetzen kann.

Fig. 2 zeigt eine vergrößerte Draufsicht auf die Bauteilversorgungsstation 1 mit einer ersten Grundplatte 3 entsprechend Fig. 1, auf die eine Fördereinheit 4 angeordnet ist. Die Fördereinheit 4 ist in der ersten Aufnahme 8 der ersten Seitenfläche 10 eingespannt, so dass bei einem Drehen der ersten Aufnahme 8 die Fördereinheit 4 ebenfalls um die erste Achse 15 mitgedreht wird. Ferner weist die erste Grundplatte 3 Einkerbungen 13 auf, die anzeigen, in welcher Orientierung sich die Fördereinheit relativ zur ersten Grundplatte 3 befindet. Die Fördereinheit 4 weist eine Schiene 12 auf, die senkrecht zur ersten Achse 15 angeordnet ist. Die Schiene 12 weist Elektromotoren (nicht dargestellt) auf, die geeignet sind, um einen Blistergurt (nicht dargestellt) zu fördern, so dass die an dem Blistergurt befestigten elektrischen Bauelemente für einen Bestückungsautomaten (in Fig. 2 nicht dargestellt) bereitstellbar sind.

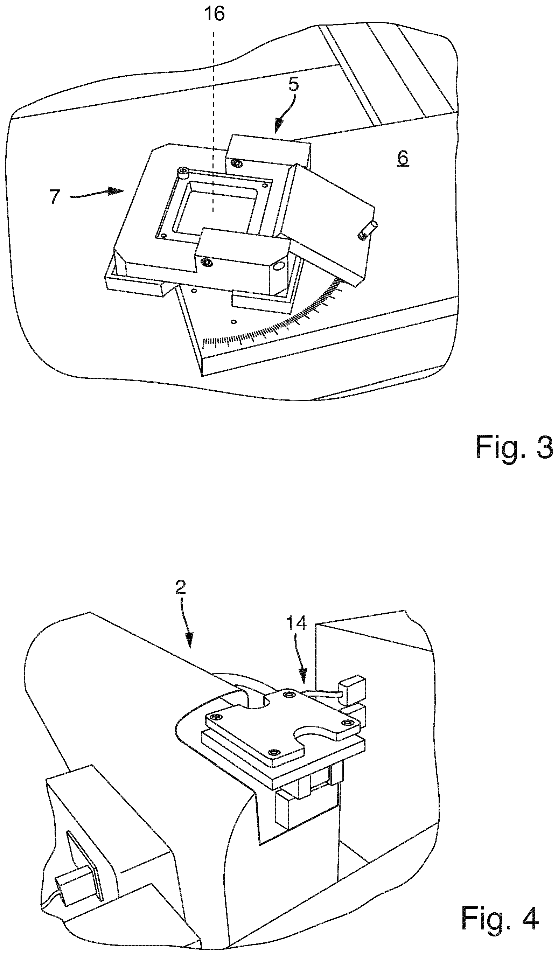

Fig. 3 zeigt eine Draufsicht auf ein Bauteilbedruckmodul 5. Das Bauteilbedruckmodul 5 umfasst eine zweite Grundplatte 6, welche die Merkmale der ersten Grundplatte (siehe Fig. 1) aufweist. Ferner umfasst das Bauteilbedruckmodul 5 einen Schablonenhalter 7, welcher drehbar um eine (gedachte) zweite Achse 16 angeordnet ist, die senkrecht zur zweiten Grundplatte 6 steht.

Fig. 4 zeigt eine perspektivische Ansicht eines Bestückungsautomaten 2 mit einer zweiten Aufnahme 14, welche sowohl die Bauteilversorgungsstation 1 als auch das Bauteilbedruckmodul 5 aufnehmen kann. Es werden jeweils die erste Grundplatte 3 der Bauteilversorgungsstation 1 oder die zweite Grundplatte 6 des Bauteilbedruckmoduls 5 in die zweite Aufnahme 14 aufgenommen.

Das erfindungsgemäße Verfahren zum Bestücken einer Leiterplatte mit elektrischen Bauelementen läuft folgendermaßen ab. Zunächst wird die erste Grundplatte 3 der Bauteilversorgungsstation 1 und die zweite Grundplatte 6 des Bauteilbedruckmoduls 5 in einer vorbestimmten Orientierung relativ zum Bestückungsautomaten 2 an den Bestückungsautomaten 2 angesteckt. Anschließend wird die Fördereinheit 4 relativ zu der ersten Achse 15 der ersten Grundplatte 3 gedreht bis die Bauelemente auf dem Blistergurt eine vorbestimmte Orientierung relativ zum Bestückungsautomaten 2 einnehmen.

Anschließend wird das Bauteilbedruckmodul 5 mit Lot versehen und relativ zu der zweiten Achse 16 gedreht, bis das Bauteilbedruckmodul 5 die Orientierung der Bauelemente aufweist. Die Bauelemente werden mittels der Vakuumpipette von der Bauteilversorgungsstation 1 entnommen und in dem Bauteilbedruckmodul 5 platziert und mit Lotpaste beaufschlagt. Anschließend werden die Bauelemente in der vorbestimmten Orientierung mittels der Vakuumpipette entnommen und in der vorbestimmten Orientierung an der Leiterplatte platziert.

### Bezugszeichenliste

- 1: Bauteilversorgungsstation
- 2: Bestückungsautomat
- 3: Erste Grundplatte
- 4: Fördereinheit
- 5: Bauteilbedruckmodul
- 6: Zweite Grundplatte
- 7: Schablonenhalter
- 8: Erste Aufnahme
- 9: Stift
- 10: Erste Seitenfläche
- 11: Zweite Seitenfläche
- 12: Schiene
- 13: Einkerbungen
- 14: Zweite Aufnahme
- 15: Erste Achse
- 16: Zweite Achse

## Patentansprüche

1. Bauteilversorgungsstation (1), bestehend aus einem Feeder für einen Bestückungsautomaten (2) zum Bereitstellen von elektrischen Bauelementen für eine Leiterplatte, umfassend
eine erste Grundplatte (3) zum Anstecken an den Bestückungsautomaten (2), so dass die erste Grundplatte (3) eine vorbestimmte Orientierung relativ zum Bestückungsautomaten (2) einnimmt,
und eine relativ zu einer zu der ersten Grundplatte (3) senkrechten ersten Achse (15) drehbar gelagerte Fördereinheit (4),
wobei die Fördereinheit (4) eine senkrecht zur der ersten Achse (15) angeordnete Schiene (12) aufweist, die Elektromotoren zum Fördern eines Blistergurtes aufweist, an dem die Bauelemente angeordnet sind, so dass die an dem Blistergurt befestigten elektrischen Bauelemente mittels der Fördereinheit (4) dem Bestückungsautomaten (2) bereitstellbar sind,
und wobei die Fördereinheit (4) derart relativ zu der ersten Achse (15) drehbar gelagert ist, dass die Bauelemente in der Ebene der ersten Grundplatte (3) in einer vorbestimmten Orientierung relativ zur senkrechten ersten Achse (15) so bereitstellbar sind, dass die Bauelemente in der vorbestimmten Orientierung mittels einer Vakuumpipette des Bestückungsautomaten (2) entnommen werden und auf der Leiterplatte in der vorbestimmten Orientierung platziert werden.

2. Bestückungsautomat (2), wobei eine Bauteilversorgungsstation (1) nach Anspruch 1 und ein Bauteilbedruckmodul (5) zum Bedrucken der Bauelemente mit Lot in eine zweite Aufnahme (14) des Bestückungsautomaten (2) aufgenommen sind, wobei das Bauteilbedruckmodul (5) relativ zu einer zur ersten Grundplatte (3) senkrechten zweiten Achse (16) drehbar gelagert ist, und wobei die erste und zweite senkrechte Achse (16) parallel zueinander angeordnet sind, so dass das Bauteilbedruckmodul (5) an die vorbestimmte Orientierung der Bauelemente anpassbar ist.

3. Bestückungsautomat (2) nach Anspruch 2, wobei das Bauteilbedruckmodul (5) eine zweite Grundplatte (6) zum Anstecken an den Bestückungsautomaten (2) aufweist, so dass die zweite Grundplatte (6) parallel zur ersten Grundplatte (3) angeordnet ist, und wobei das Bauteilbedruckmodul (5) einen Schablonenhalter (7) aufweist, der auf der zweiten Grundplatte (6) angeordnet ist und relativ zur zweiten senkrechten Achse (16) drehbar gelagert ist, so dass die Bauelemente in der vorbestimmten Orientierung in dem Schablonenhalter (7) platzierbar sind.

4. Bestückungsautomat (2) nach Anspruch 2 oder 3, wobei die erste und zweite Grundplatte (3, 6) als eine einzige Grundplatte ausgebildet sind, auf der sowohl die Fördereinheit (4) als auch das Bauteilbedruckmodul (5) angeordnet ist.

5. Verfahren zum Bestücken einer Leiterplatte mit elektrischen Bauelementen, mittels einer Bauteilversorgungsstation (1) bestehend aus einem Feeder für einen Bestückungsautomaten (2) zum Bereitstellen von elektrischen Bauelementen für eine Leiterplatte, wobei die Bauteilversorgungsstation (1) eine erste Grundplatte (3) mit einer relativ zu einer zu der ersten Grundplatte (3) senkrechten ersten Achse (15) drehbar gelagerte Fördereinheit (4), wobei die Fördereinheit (4) eine senkrecht zur der ersten Achse (15) angeordnete Schiene (12) aufweist, die Elektromotoren zum Fördern eines Blistergurtes, an dem die Bauelemente angeordnet sind, aufweist,
umfassend die Verfahrensschritte,
Anstecken der ersten Grundplatte (3) an den Bestückungsautomaten (2), so dass die erste Grundplatte (3) eine vorbestimmte Orientierung relativ zum Bestückungsautomaten (2) einnimmt,
Drehen der Fördereinheit (4) relativ zu r der zu der ersten Grundplatte (3), senkrechten ersten Achse (15), um die Bauelemente in der Ebene der ersten Grundplatte (3) in einer vorbestimmten Orientierung relativ zur senkrechten ersten Achse (15) bereitzustellen,
Entnehmen des Bauelements in der vorbestimmten Orientierung mittels einer Vakuumpipette,
Platzieren des Bauelements in der vorbestimmten Orientierung auf der Leiterp latte.

6. Verfahren nach Anspruch 5, wobei ein Bauteilbedruckmodul (5) zum Bedrucken der Bauelemente mit Lot vorgesehen ist, und wobei das Bauteilbedruckmodul (5) relativ zu einer zu einer zweiten Grundplatte (6) senkrechten zweiten Achse (16) gedreht wird, um das Bauteilbedruckmodul (5) an die vorbestimmte Orientierung der Bauelemente anzupassen, und wobei die Bauelemente nach dem Entnehmen mittels der Vakuumpipette und vor dem Platzieren an der Leiterplatte an dem Bauteilbedruckmodul (5) platziert werden, um mit Lotpaste beaufschlagt zu werden.

## Claims

1. Component supply station (1) consisting of a feeder for a placement machine (2) for the provisioning of electrical components for a printed circuit board, comprising a first base plate (3) for attachment to the placement machine (2) in such a way that the first base plate (3) adopts a predefined orientation in relation to the placement machine (2),
and a conveyor unit (4) which is pivoted in relation to a first axis (15) perpendicular to the first base plate (3),
wherein the conveyor unit (4) has a rail (12) that is perpendicular to the first axis (15), said rail having electromotors for transporting a blister belt on which the components are arranged such that the electrical components secured to the blister belt can be provisioned to the placement machine (2) by means of the conveyor unit (4),
and wherein the conveyor unit (4) is pivoted in relation to the first axis (15) in such a way that the components on the plane of the first base plate (3) can be provisioned in a predetermined orientation in relation to the perpendicular first axis (15) in such a way that the components are removed in a predefined orientation by means of a vacuum pipette of the placement machine (2) and placed on the printed circuit board in the predefined orientation.

2. Placement machine (2), wherein a component supply station (1) as claimed in Claim 1 and a component imprinting module (5) for imprinting the components with solder are accepted into a second holder (14) of the placement machine (2), wherein the component imprinting module (5) is pivoted in relation to a second axis (16) perpendicular to the first base plate (3), and wherein the first and second axis (16) are arranged parallel to one another such that the component imprinting module (5) can be adapted to the predefined orientation of the components.

3. Placement machine (2) as claimed in Claim 2, wherein the component imprinting module (5) comprises a second base plate (6) for attachment to the placement machine (2) such that the second base plate (6) is arranged parallel to the first base plate (3), and wherein the component imprinting module (5) has a stencil holder (7), which is arranged on the second base plate (6) and is pivoted in relation to the second perpendicular axis (16) in such a way that the components can be placed in the stencil holder (7) in the predefined orientation.

4. Placement machine (2) as claimed in Claim 2 or 3, wherein the first and the second base plate (3, 6) are designed as a single base plate on which both the conveyor unit (4) and the component imprinting module (5) are arranged.

5. Procedure for assembling a printed circuit board with electrical components using a component supply station (1) consisting of a feeder for a placement machine (2) for the provisioning of electrical components for a printed circuit board, wherein the component supply station (1) has a first base plate (3) with a conveyor unit (4) that is pivoted in relation to a first axis (15) that is perpendicular in relation to the first base plate (3), wherein the conveyor unit (4) has a rail (12) that is arranged in a perpendicular manner to the first axis (15), said rail having electromotors for the conveying of a blister belt on which the components are arranged,
said procedure comprising the following steps:
Attachment of the first base plate (3) to the placement machine (2) in such a way that the first base plate (3) adopts a predefined orientation in relation to the placement machine (2),
Rotation of the conveyor unit (4) in relation to the first axis (15) which is perpendicular to the first base plate (3) in order to provision the components on the plane of the first base plate (3) in a predefined orientation in relation to the perpendicular first axis (15),
Removal of the component in the predefined orientation using a vacuum pipette, Placement of the component on the printed circuit board in the predefined orientation.

6. Procedure as claimed in Claim 5, wherein a component imprinting module (5) for imprinting the components is provided with solder, and wherein the component imprinting module (5) is rotated relative to a second axis (16) that is perpendicular to the second base plate (6) in order to adapt the component imprinting module (5) to the predefined orientation of the components, and procedure wherein the components are placed on the component imprinting module (5) after they are removed with a vacuum pipette and before they are placed on the printed circuit board in order to apply solder paste to said components.

## Revendications

1. Station d'alimentation de composants (1) constituée d'un dispositif d'alimentation (2), destinée à la mise à disposition de composants électriques pour un circuit imprimé, comprenant
une première plaque de base (3) à rattacher à la machine d'implantation de composants (2), de telle sorte que la première plaque de base (3) adopte une orientation prédéfinie par rapport à la machine d'implantation de composants (2), et une unité de transport (4) apte à pivoter autour d'un premier axe (15) perpendiculaire à la première plaque de base (3),
station pour laquelle l'unité de transport (4) comporte un rail disposé perpendiculairement au premier axe (15), lequel rail comporte des moteurs électriques destinés au transport d'une bande de blister sur laquelle sont disposés les composants, de telle sorte que les composants électriques fixés sur la bande de blister puissent être mis à la disposition de la machine d'implantation de composants (2) au moyen de l'unité de transport (4),
et station pour laquelle l'unité de transport (4) est apte à pivoter autour du premier axe (15) de telle sorte que les composants puissent être mis à disposition dans le plan de la première plaque de base (3) selon une orientation prédéfinie par rapport au premier axe (15), afin que les composants soient prélevés selon l'orientation prédéfinie au moyen d'une pipette à vide de la machine d'implantation de composants (2) et placés sur le circuit imprimé selon l'orientation prédéfinie.

2. Machine d'implantation de composants (2), pour laquelle une station d'alimentation de composants (1) selon la revendication 1 et un module d'impression de composants (5) destiné à l'impression des composants avec de la soudure sont logés dans un deuxième support (14) de la machine d'implantation de composants (2), le module d'impression de composants (5) pouvant être pivoté autour d'un deuxième axe (16) perpendiculaire à la première plaque de base (3), et le premier et le deuxième axes (16) perpendiculaires étant disposés parallèlement, de manière à ce que le module d'impression de composants (5) puisse être adapté à l'orientation prédéfinie des composants.

3. Machine d'implantation de composants (2) selon la revendication 2, pour laquelle le module d'impression de composants (5) comprend une deuxième plaque de base (6) à rattacher à la machine d'implantation de composants (2), de telle sorte que la deuxième plaque de base (6) soit disposée parallèlement à la première plaque de base (3), et
pour laquelle le module d'impression de composants (5) comporte un support de gabarit (7), lequel est disposé sur la deuxième plaque de base (6) et peut être pivoté autour du deuxième axe (16) perpendiculaire de telle manière que les composants puissent être placés selon l'orientation prédéfinie dans le support de gabarit (7).

4. Machine d'implantation de composants (2) selon la revendication 2 ou 3, pour laquelle la première et la deuxième plaques de base (3, 6) sont conçues en tant que plaque de base unique, sur laquelle sont disposés à la fois l'unité de transport (4) et le module d'impression de composants (5).

5. Procédé destiné à l'implantation sur un circuit imprimé de composants électriques au moyen d'une station d'alimentation de composants (1) constituée d'un dispositif de chargement pour une machine d'implantation de composants (2), destiné à mettre à disposition des composants électriques pour un circuit imprimé, la station d'alimentation de composants (1) comportant une première plaque de base (3) avec une unité de transport (4) apte à pivoter autour d'un premier axe (15) perpendiculaire par rapport à la première plaque de base (3), l'unité de transport (4) comportant un rail (12) disposé perpendiculairement au premier axe (15), lequel rail comporte des moteurs électriques destinés au transport d'une bande de blister sur laquelle sont disposés les composants, lequel procédé comprend les étapes suivantes :
Rattachement de la première plaque de base (3) à la machine d'implantation de composants (2) de telle manière que la première plaque de base (3) adopte une orientation prédéfinie par rapport à la machine d'implantation de composants (2), Rotation de l'unité de transport (4) autour du premier axe (15) perpendiculaire à la première plaque de base (3), afin de mettre à disposition les composants dans le plan de la première plaque de base (3) selon une orientation prédéfinie par rapport au premier axe (15) perpendiculaire,
Prélèvement du composant selon l'orientation prédéfinie au moyen d'une pipette à vide,
Mise en place du composant selon l'orientation prédéfinie sur le circuit imprimé.

6. Procédé selon la revendication 5, pour lequel est prévu un module d'impression de composants (5) destiné à l'impression des composants avec de la soudure, et pour lequel le module d'impression de composants (5) est tourné par rapport à un deuxième axe (16) perpendiculaire à une deuxième plaque de base (6), afin d'adapter le module d'impression de composants (5) à l'orientation prédéfinie des composants, et procédé pour lequel les composants - après avoir été prélevés au moyen de la pipette à vide et avant leur mise en place sur le circuit imprimé - sont placés sur le module d'impression de composants (5) en vue de l'application de pâte à souder sur ces derniers.
